# EUROPÄISCHE PATENTSCHRIFT

(11) **EP 2 590 493 B1**
(45) Veröffentlichungstag und Bekanntmachung des Hinweises auf die Patenterteilung: **27.03.2019**
(21) Anmeldenummer: 12191573.0
(22) Anmeldetag: 07.11.2012
(51) Int. Cl.: H05K 7/20, H05K 7/14

(54) **Frequenzumrichter**
Frequency inverter
Convertisseur de fréquence

(30) Priorität: 07.11.2011 DE 102011085870
(43) Veröffentlichungstag der Anmeldung: 08.05.2013
(73) Patentinhaber: Lenze Automation GmbH, 31855 Aerzen (DE)
(72) Erfinder: Neumann, Edmund, 31789 Hameln (DE); Wempe, Andreas, 31855 Groß Berkel (DE)
(74) Vertreter: Patentanwälte Ruff, Wilhelm, Beier, Dauster & Partner mbB

(56) Entgegenhaltungen:
- EP-A2- 1 921 903
- WO-A1-91/19415
- WO-A1-2005/002306
- WO-A2-2006/051927
- DE-A1-102006 034 777

## Beschreibung

Die Erfindung betrifft einen Frequenzumrichter mit einer Platine, einem darauf angebrachten Leistungselektronik-Modul sowie einem Kühlkörper. Dabei weist eine Unterseite des Leistungselektronik-Moduls in Richtung der Platine. Die an der Unterseite vorgesehenen Kontaktabschnitte des Leistungselektronik-Moduls sind mit der Platine verlötet. Das Leistungselektronik-Modul weist weiterhin eine Wärmeauskopplungsfläche auf, die mit einer Haupterstreckungsebene der Platine einen Winkel von 90° (+/- 10°) einschließt. Korrespondierend hierzu verfügt der Kühlkörper über eine Wärmeeinkopplungsfläche, die flächig an der Wärmeauskopplungsfläche des Leistungselektronik-Moduls anliegt.

Leistungselektronik-Module für einen gattungsgemäßen Frequenzumrichter, bei denen es sich vorliegend insbesondere um IGBT-Module ("Insulated-Gate Bipolar Transistor") handeln kann, sind beispielsweise vom Hersteller Tyco erhältlich. Eine Besonderheit bei diesem besonderen Typ liegt darin, dass die genannte Wärmeauskopplungsfläche nicht auf der gegenüberliegenden Seite zur mit der Platine verbundenen Unterseite des Leistungselektronik-Moduls angeordnet ist, sondern mit dieser Unterseite einen rechten Winkel einschließt. Dementsprechend ist der Kühlkörper so angeordnet, dass seine Wärmeeinkopplungsfläche sich ebenfalls orthogonal zur Haupterstreckungsebene der Platine erstreckt. Die Flächennormalen der Wärmeeinkopplungsfläche und der Platine schließen also einen rechten Winkel ein. Diese Art der Leistungselektronik-Module gestattet eine vergleichsweise flache Bauweise des Frequenzumrichters.

Um einen besonders guten Wärmeübergang zwischen der Wärmeauskopplungsfläche des Leistungselektronik-Moduls und der Wärmeeinkopplungsfläche des metallischen Kühlkörpers zu erzielen, ist bei gattungsgemäßen Frequenzumrichtern vorgesehen, dass die Wärmeeinkopplungsfläche und die Wärmeauskopplungsfläche mittels mindestens einer von der Seite des Leistungselektronik-Moduls aus eingeschraubten Schraube aneinander angepresst werden.

Beispielsweise ist aus WO 2005/002306 A1 ein Frequenzumrichter mit einer Platine und einem darauf angebrachten Leistungselektronik-Modul bekannt, wobei ein Kühlkörper mittels Schrauben an dem Leistungselektronik-Modul angebracht ist. Gemäß WO 2005/002306 A1 ist eine Halteeinrichtung vorgesehen, an welcher ein Hilfs-Kühlkörper mittels ersten Schrauben angebracht ist. Der Kühlkörper ist mittels zweiten Schrauben an dem Hilfs-Kühlkörper angebracht.

Aus WO 91/19415 A1 ist es bekannt, einen Kühlkörper mittels einer Schraube anzubringen, welche in ein in den Kühlkörper eingeschnittenes Gewinde eingeschraubt wird.

Nachteilig an dieser Gestaltung ist es, dass diese Schraube in ein in den Kühlkörper eingeschnittenes Gewinde oder aber in eine jenseits einer Durchbrechung des Kühlkörpers angeordnete Mutter eingeschraubt werden muss. Insbesondere letzteres erschwert die Montage. Auch ist die Zugänglichkeit dieser Schraube nach der Montage nachteilig, da sie eine unsachgemäße Handhabung durch nicht qualifiziertes Personal ermöglicht.

### Aufgabe und Lösung

Aufgabe der Erfindung ist es, einen gattungsgemäßen Frequenzumrichter dahingehend weiterzubilden, dass dieser eine erleichterte Montage und/oder eine erschwerte Demontage ermöglicht.

Diese Aufgabe wird gelöst durch den Frequenzumrichter mit den Merkmalen des Anspruchs 1.

Erfindungsgemäß ist hierfür vorgesehen, dass die mindestens eine Schraube zum Anpressen des Kühlkörpers an das Leistungselektronik-Modul sich von der Seite des Kühlkörpers aus durch eine erste Ausnehmung im Kühlkörper in eine zweite Ausnehmung am Leistungselektronik-Modul erstreckt und in ein in der zweiten Ausnehmung oder in ein hinter der zweiten Ausnehmung vorgesehenes Innengewinde einer Halteeinrichtung eingeschraubt ist.

Bei einer erfindungsgemäßen Gestaltung ist somit vorgesehen, dass die Schraube nicht in Blickrichtung vom Schraubenkopf zum distalen Ende des Schraubengewindes vom Leistungselektronik-Modul in den Kühlkörper und eine gegebenenfalls dort anzuordnende Mutter hineinragt, sondern aus Richtung des Kühlkörpers in Richtung des Leistungselektronik-Moduls weist. Zur Anbringung des Kühlkörpers am Leistungselektronik-Modul wird daher eine Schraube vom Kühlkörper aus durch eine im Kühlkörper vorgesehene Durchbrechung, wie beispielsweise eine Durchgangsbohrung, hindurchgeführt. Diese Schraube ragt in Richtung ihres distalen Endes durch eine zweite Ausnehmung am Leistungselektronik-Modul, wobei es sich hierbei im einfachsten Falle um ein unmittelbar am Leistungselektronik-Modul vorgesehenes Innengewinde handeln kann. Die komplizierte Handhabung einer Mutter im Bereich des Kühlkörpers entfällt somit. Das Festschrauben erfolgt auf der Seite des Kühlkörpers, so dass die Handhabung eines Schraubwerkzeugs in unmittelbarer Nähe der Platine entfallen kann.

Selbst bei einer Gestaltung der Erfindung, bei der die Verwendung einer Mutter statt am Kühlkörper am Leistungsmodul vorgesehen ist, ist dies hinsichtlich der Montage gegenüber bisherigen Gestaltungen von Vorteil, da die Handhabung der Mutter am Leistungselektronik-Modul aufgrund der besseren Zugänglichkeit leichter ist. Die gegenüber der bekannten Erstreckungsrichtung der mindestens einen Schraube gegenläufige erfindungsgemäße Erstreckungsrichtung kann darüber hinaus dafür sorgen, dass im Falle einer Anbringung des Frequenzumrichters mittels des Kühlkörpers an einer Schaltschrankwandung die Demontage des Leistungselektronik-Moduls wirksam verhindert wird, da die Schraubenköpfe nicht zugänglich sind.

Ein weiterer Vorteil, der durch die erfindungsgemäße Gestaltung erzielt wird, liegt darin, dass die Montagereihenfolge hierdurch freier gestaltet werden kann. Dies gilt für den Fall, dass auf der Seite der Platine Bauteile oder Zusatzplatinen vorgesehen sind, die ein Verschrauben des Leistungselektronik-Moduls von dieser Seite aus stark erschwert oder unmöglich macht. In solchen Fällen wurde bislang die Befestigung der Leistungselektronik-Module am Kühlkörper frühzeitig vorgenommen, um erst anschließend die weiteren Bauteile oder Zusatzplatinen zu montieren. Dagegen gestattet die erfindungsgemäße Lösung die Fertigstellung der Platine vor deren Anbringung am Kühlkörper.

Unter einem Leistungselektronik-Modul wird im Zusammenhang mit der vorliegenden Erfindung ein Modul mit einem Gehäuse und hierin enthaltener Leistungselektronik-Komponenten verstanden. Bei dem Gehäuse handelt es sich vorzugsweise um ein Kunststoffgehäuse, welches eine metallische Außenfläche aufweist, die die Wärmeauskopplungsfläche bildet. Dieses im Kontext dieser Erfindung zu verwendende Leistungselektronik-Modul ist dafür ausgebildet, in der beschriebenen Art und Weise auf eine Platine aufgelötet zu werden.

Beim vorzugsweise metallischen Kühlkörper handelt es sich um einen metallischen Körper, der gegenüber der Wärmeauskopplungsfläche eine deutlich vergrößerte Oberfläche aufweist, so dass die Abgabe von Wärme in eine Umgebung hierdurch verbessert wird. Vorzugsweise stellt der Kühlkörper gleichzeitig jenen Teil des Frequenzumrichters dar, der Anbringungsmittel, wie beispielsweise Bohrungen, zur Verfügung stellt, die die Anbringung an einer Anbringungsfläche wie einer Schaltschrankwand ermöglichen.

Es ist eine separate Halteeinrichtung vorgesehen, die unabhängig vom Leistungselektronik-Modul durch eine eigene Lötverbindung an der Platine befestigt ist. Das Innengewinde kann einstückiger Teil dieser Halteeinrichtung sein, also insbesondere in ein Blech eingeschnitten sein, aus welchem die Halteeinrichtung hergestellt worden ist. Auch ist es stattdessen möglich, dass an der Halteeinrichtung eine Mutter drehgesichert befestigt ist, die ihrerseits das Innengewinde zur Verfügung stellt.

Die Gestaltung mit einer solchen vom Leistungselektronik-Modul separaten Halteeinrichtung sieht vor, dass das an dieser Befestigungsvorrichtung vorgesehene Innengewinde bezogen auf das Leistungselektronik-Modul auf der zum Kühlkörper gegenüberliegenden Seite angeordnet ist. Die Schraubverbindung führt demnach dazu, dass das Leistungselektronik-Modul zwischen der Halteeinrichtung und dem Kühlkörper gleichsam festgeklemmt wird.

Die Halteeinrichtung ist ebenso wie das Leistungselektronik-Modul auf die Platine aufgelötet. Somit kann sie im Zuge eines einheitlichen Fertigungsschrittes gemeinsam mit dem Leistungselektronik-Modul mit der Platine verbunden werden. Der Vorteil der Verwendung einer solchen Halteeinrichtung gegenüber einem Leistungselektronik-Modul, welches das Innengewinde selbst zur Verfügung stellt, liegt in der Flexibilität der Anwendung. Das Leistungselektronik-Modul bedarf gegenüber herkömmlichen Gestaltungen keiner Anpassung. Das auf Seiten des Leistungselektronik-Moduls vorgesehene Gewinde wird in separater Weise durch die Halteeinrichtung zur Verfügung gestellt.

Von Vorteil ist es, wenn nicht eine einzige, sondern mindestens zwei Halteeinrichtungen vorgesehen sind, die jeweils mittels einer Lötverbindung mit der Platine verbunden sind und die jeweils ein Innengewinde für eine von der Seite des Kühlkörpers aus eingeschraubte Schraube aufweisen. Dabei ist vorgesehen, dass die mindestens zwei Schrauben beide durch jeweils eine zweite Ausnehmung am Kühlkörper erstreckt sind und jenseits dieser jeweiligen Ausnehmung in das Innengewinde je einer der Halteeinrichtungen eingeschraubt sind.

Die Halteeinrichtungen können als separate Halteeinrichtungen ausgebildet sein, die jeweils an der Hauptplatine befestigt sind. Es hat sich jedoch als vorteilhaft herausgestellt, wenn die beiden Halteeinrichtungen miteinander über eine Traverse verbunden sind, die das Leistungselektronik-Modul überspannt. In einem solchen Falle ist somit eine das Leistungselektronik-Modul überspannende Befestigungsvorrichtung vorgesehen, die gleichsam die zwei genannten Halteeinrichtungen in sich vereint. Die Traverse bewirkt, dass eine Trennung des Leistungselektronik-Moduls von der Platine erschwert wird. Gleichzeitig werden die mittels der Traverse miteinander verbundenen Halteeinrichtungen zusätzlich stabilisiert.

### Kurzbeschreibung der Zeichnungen

Weitere Aspekte und Vorteile der Erfindung ergeben sich außer aus den Ansprüchen auch aus der nachfolgenden Beschreibung eines bevorzugten Ausführungsbeispiels der Erfindung, welches nachfolgend anhand der Figuren erläutert wird. Dabei zeigen:
- Figur 1: einen erfindungsgemäßen Frequenzumrichter in einer Gesamtdarstellung,
- Figur 2: eine Detaildarstellung eines auf der Platine des Frequenzumrichters der Figur 1 angeordneten Leistungselektronik-Moduls, welches benachbart zu einem Kühlkörper des Frequenzumrichters angeordnet ist,
- Figur 3: eine Schnittdarstellung durch den Frequenzumrichter im Bereich des Kühlkörpers und des Leistungselektronik-Moduls und
- Figur 4: eine Explosionsdarstellung der im Kontext der Erfindung wesentlichen Komponenten des erfindungsgemäßen Frequenzumrichters.

### Detaillierte Beschreibung des Ausführungsbeispiels

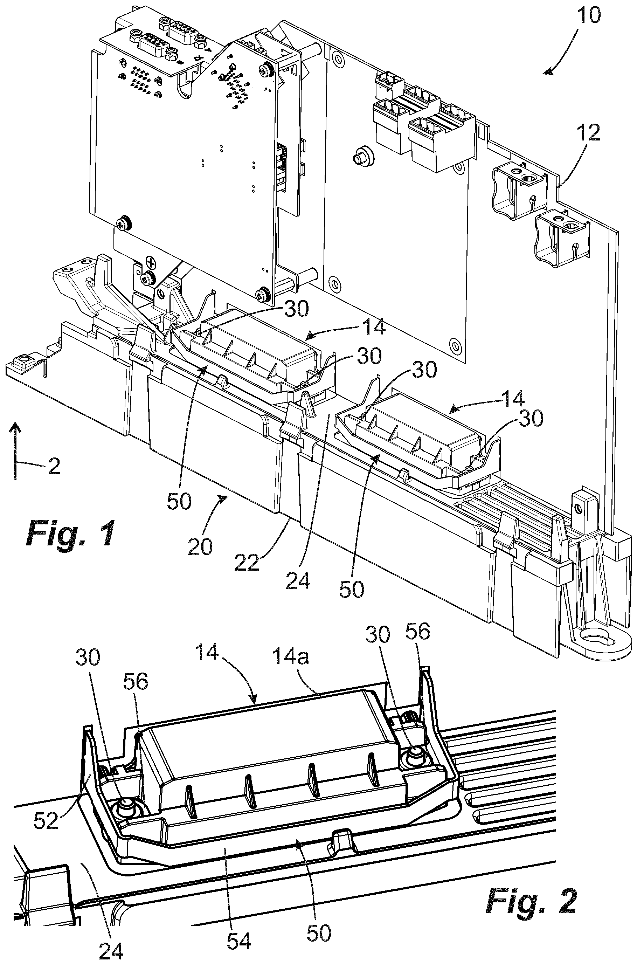

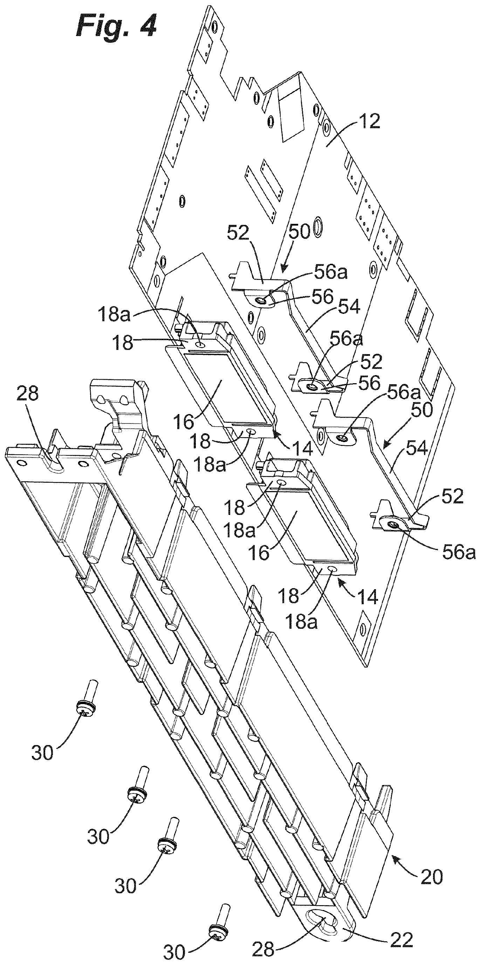

Figur 1 zeigt einen erfindungsgemäßen Frequenzumrichter 10 in einer Gesamtdarstellung, wobei eine Kunststoffhaube des Frequenzumrichters 10 in der Darstellung der Figur 1 bereits entfernt ist. Anhand von Fig. 1 sowie der Detaildarstellung der Fig. 2 und der Explosionsdarstellung der Fig. 4 wird der Aufbau des Frequenzumrichters 10 nachfolgend erläutert.

Hauptkomponenten des Frequenzumrichters sind eine Platine 12, auf der verschiedene elektronische Komponenten zur Frequenzumwandlung angeordnet sind. Hierzu gehören auch zwei IGBT-Module 14, die bezogen auf die Darstellung der Figur 1 am unteren Rand der Platine 12 vorgesehen sind. Die Platine 12 ist in nicht näher dargestellter Weise mit einem Kühlkörper 20 verschraubt. Dieser Kühlkörper 20 bildet mit seiner der Platine 12 abgewandten Seite eine Anbringungsfläche 22, die zur Anbringung an einer Wandung eines Schaltschranks vorgesehen ist. Hierfür sind Befestigungsvorrichtungen 28 in Form von Aussparungen für Befestigungsschrauben am Kühlkörper 20 vorgesehen.

Die über den Kühlkörper 20 abzuleitende Wärme ist insbesondere jene Verlustwärme, die an den IGBT-Modulen 14 entsteht. Die IGBT-Module 14 weisen daher auf ihrer bezogen auf die Darstellung der Figur 1 nach unten weisenden Seite eine metallische Wärmeauskopplungsfläche 16 auf, die in der Perspektive der Figur 1 nicht zu erkennen ist. Diese liegt an einer nach oben weisenden Wärmeeinkopplungsfläche 24 des Kühlkörpers 20 an.

Damit die Verlustwärme der IGBT-Module 14 möglichst effizient abgeführt werden kann, müssen die Wärmeauskopplungsfläche 16 der IGBT-Module 14 und die Wärmeankopplungsfläche 24 des Kühlkörpers 20 bündig aneinander anliegen. Um dies zu gewährleisten, ist vorgesehen, dass der Kühlkörper 20 und die IGBT-Module 14 nicht nur mittelbar über die Platine 12 miteinander verbunden sind, sondern zusätzlich durch Schraubverbindungen mit Schrauben 30 aneinander angepresst werden. Diese Schrauben 30 erstrecken sich parallel zur Haupterstreckungsebene der Platine 12 und orthogonal zu den Wärmeauskopplungsflächen 16 der IGBT-Module 14 und der Wärmeeinkopplungsfläche 24 des Kühlkörpers 20.

Die Schrauben 30 sind dabei bezogen auf die Perspektive der Figur 1 und in der durch den Pfeil 2 verdeutlichten Weise in Hochrichtung nach oben eingeschraubt. Sie erstrecken sich in nachfolgend noch näher erläuterter Weise durch eine Durchbrechung 26 im Kühlkörper 20 und eine Ausnehmung oder Bohrung 18a an seitlichen Befestigungsflanschen 18 der IGBT-Module 14. Jenseits dieser Befestigungsflansche 18 sind die Schrauben 30 in Innengewinde 56a eingeschraubt. Die jeweils zwei Innengewinde 56a sind nicht an den IGBT-Modulen 14 selbst vorgesehen. Stattdessen ist zu jedem IGBT-Modul 14 eine Befestigungsvorrichtung 50 vorgesehen. Diese sind in Art eines Metallbügels ausgebildet. Jede Befestigungsvorrichtung 50 überspannt dabei in der insbesondere aus Figur 2 ersichtlichen Weise eines der IGBT-Module 14.

Im Einzelnen weist jede der Befestigungsvorrichtungen 50 zwei Befestigungsarme 52 auf, welche jeweils an der Platine 12 festgelötet sind. Die beiden Befestigungsarme 52 sind miteinander über die das jeweilige IGBT-Modul 14 überspannende Traverse 54 verbunden. An den Befestigungsarmen 52 sind jeweils aufeinander zu weisende Befestigungslaschen 56 vorgesehen, die über die genannten Gewindebohrungen 56a verfügen oder die mit Muttern versehen sind, die die genannten Gewindebohrungen 56a aufweisen.

Durch die Verschraubung des Kühlkörpers 20 mit den IGBT-Modulen 14 mit von Seiten des Kühlkörpers eingeschraubten Schrauben kann die Montage erleichtert werden, da die Handhabung eines Schraubwerkzeugs nicht in unmittelbarer Nähe der Platine 12 erfolgen muss. Auch ist nach Anbringung des Frequenzumrichters 10 an einer Schrankwandung die Zugänglichkeit der Schrauben 30 stark eingeschränkt, so dass das Herausschrauben dieser Schrauben 30 durch nicht ausreichend qualifizierte Personen erschwert wird.

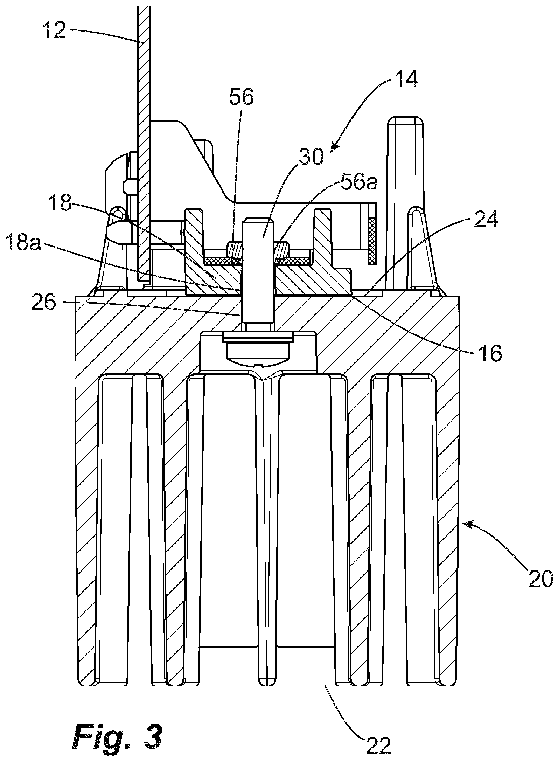

Figur 3 verdeutlicht den Aufbau nochmals im Querschnitt. Auf der Platine 12 ist das IGBT-Modul 14 mittels stiftartiger Kontaktabschnitte verlötet. Die bei dieser Anordnung dieses IGBT-Moduls 14 und bei der Darstellung der Figur 3 nach unten weisende Wärmeauskopplungsfläche 16 liegt an einer Wärmeeinkopplungsfläche 24 des Kühlkörpers 20 an. Die hier gewünschte Anpresskraft wird über eine Schraubverbindung erzielt. Die in Figur 3 dargestellte Schraube 30 ist vom Kühlkörper 20 aus durch eine darin vorgesehene Durchgangsbohrung 26, durch die Ausnehmung 18a am IGBT-Modul 14 bis in die Gewindebohrung 56a der Befestigungsvorrichtung 50 eingeschraubt.

## Patentansprüche

1. Frequenzumrichter (10) mit
- einer Platine (12),
- einem Leistungselektronik-Modul (14),
- dessen Unterseite (14a) in Richtung der Platine (12) weist,
- das an der Unterseite (14a) Kontaktabschnitte aufweist, die mit der Platine (12) verlötet sind, und
- das eine Wärmeauskopplungsfläche (16) aufweist, die mit einer Haupterstreckungsebene der Platine (12) einen rechten Winkel einschließt,
- einem Kühlkörper (20) mit einer Wärmeeinkopplungsfläche (24), die flächig an der Wärmeauskopplungsfläche (16) des Leistungselektronik-Modul (14) anliegt, und
- mindestens einer Halteeinrichtung (52), die unabhängig vom Leistungselektronik-Modul (14) an der Platine (12) befestigt ist, wobei
- die Wärmeeinkopplungsfläche (24) mittels mindestens einer Schraube (30) an die Wärmeauskopplungsfläche (16) angepresst wird,
**dadurch gekennzeichnet, dass**
- die mindestens eine Halteeinrichtung (52) durch eine Lötverbindung an der Platine (12) befestigt ist,
- die die mindestens eine Halteeinrichtung (52) ein Innengewinde (56a) aufweist, wobei das Innengewinde (56a) einstückiger Teil dieser Halteeinrichtung (52) oder Teil einer drehgesichert an der Halteeinrichtung (52) vorgesehenen Mutter ist, und
- die Schraube (30) sich von der Seite des Kühlkörpers (20) aus durch eine erste Ausnehmung (26) im Kühlkörper und durch eine zweite Ausnehmung (18a) am Leistungselektronik-Modul (14) erstreckt und in das hinter der zweiten Ausnehmung vorgesehenes Innengewinde (56a) der Halteeinrichtung eingeschraubt ist.

2. Frequenzumrichter nach Anspruch 1,
**dadurch gekennzeichnet, dass**
mindestens zwei Halteeinrichtungen (52) vorgesehen sind, die jeweils durch eine Lötverbindung an der Platine (12) befestigt sind und die jeweils ein Innengewinde (56a) für eine von der Seite des Kühlkörpers (20) aus eingeschraubt Schraube (30) aufweisen.

3. Frequenzumrichter nach Anspruch 2,
**dadurch gekennzeichnet, dass**
die beiden Halteeinrichtungen (52) miteinander über eine Traverse (54) verbunden sind, die das Leistungselektronik-Modul (14) überspannt.

## Claims

1. Frequency converter (10), comprising
- a circuit board (12),
- a power electronics module (14),
- a bottom side (14a) thereof facing towards the circuit board (12),
- said module including contact sections on the bottom side (14a), which sections are soldered to the circuit board (12), and
- said module including a heat output surface (16) which is at right angles to a main extension plane of the circuit board (12),
- a heat sink (20) having a heat input surface (24) resting flat on the heat output surface (16) of the power electronics module (14), and
- at least one holding device (52) which is fixed to the circuit board (12) independent of the power electronics module (14),
wherein
- the heat input surface (24) is pressed onto the heat output surface (16) by means of at least one screw (30),
**characterized in that**
- the at least one holding device (52) is fixed to the circuit board (12) by a solder connection,
- the at least one holding device (52) has an internal thread (56a), wherein the internal thread (56a) is an integral part of said holding device (52) or part of a nut provided on the holding device (52) fixed against rotation, and
- the screw (30) extends starting from the side of the heat sink (20) through a first recess (26) in the heat sink and through a second recess (18a) on the power electronics module (14) and is screwed into the internal thread (56a) of the holding device provided behind the second recess.

2. Frequency converter according to claim 1, **characterized in that**
at least two holding devices (52) are provided, each fixed to the circuit board (12) by a solder connection, and each including an internal thread (56a) for a screw (30) screwed in from the side of the heat sink (20).

3. Frequency converter according to claim 2, **characterized in that**
the two holding devices (52) are interconnected via a cross member (54) which spans the power electronics module (14).

## Revendications

1. Convertisseur de fréquence (10) comportant
- une carte de circuit imprimé (12),
- un module électronique de puissance (14),
- dont la face inférieure (14a) est tournée vers le circuit imprimé (12),
- qui comporte des parties de contact soudées à la carte (12) sur sa face inférieure (14a), et
- qui comporte une surface de découplage thermique (16) formant un angle droit avec un plan d'extension principal de la carte de circuit imprimé (12),
- un dissipateur thermique (20) comportant une surface de couplage thermique (24) qui repose à plat contre la surface de découplage thermique (16) du module électronique de puissance (14), et
- au moins un dispositif de maintien (52) qui est fixé à la carte de circuit imprimé (12) indépendamment du module électronique de puissance (14),
dans lequel
- la surface de couplage thermique (24) est comprimée contre la surface de découplage thermique (16) au moyen d'au moins une vis (30),
**caractérisé en ce que**
- ledit au moins un dispositif de maintien (52) est fixé à la carte de circuit imprimé (12) par une liaison soudée,
- ledit au moins un dispositif de maintien (52) présente un filetage intérieur (56a), le filetage intérieur (56a) faisant partie intégrante dudit dispositif de maintien (52) ou faisant partie d'un écrou qui est prévu solidaire en rotation sur le dispositif de maintien (52), et
- la vis (30) s'étend depuis le côté du dissipateur thermique (20), à travers un premier évidement (26) ménagé dans le dissipateur thermique et à travers un deuxième évidement (18a) ménagé sur le module électronique de puissance (14), et est vissée dans le filetage intérieur (56a) du dispositif de maintien, prévu à l'arrière du deuxième évidement.

2. Convertisseur de fréquence selon la revendication 1,
**caractérisé en ce qu'**il est prévu au moins deux dispositifs de maintien (52) qui sont respectivement fixés à la carte (12) par une liaison soudée et qui présentent chacun un filetage intérieur (56a) destiné à une vis (30) vissée depuis le côté du dissipateur thermique (20).

3. Convertisseur de fréquence selon la revendication 2,
**caractérisé en ce que** les deux dispositifs de maintien (52) sont reliés l'un à l'autre par une traverse (54) qui enjambe le module électronique de puissance (14).
